# EUROPÄISCHE PATENTANMELDUNG

(11) **EP 3 901 996 A2**
(43) Veröffentlichungstag der Anmeldung: **27.10.2021**
(21) Anmeldenummer: 21164902.5
(22) Anmeldetag: 25.03.2021
(51) Int. Cl.: H01L 21/603, H01L 23/488, H01L 23/482, H01L 23/485, H01L 21/98, H01L 25/07, H01L 23/64, H01L 23/538

(54) **VERFAHREN ZUR VERBINDUNG VON KOMPONENTEN BEI DER HERSTELLUNG LEISTUNGSELEKTRONISCHER MODULE ODER BAUGRUPPEN MIT DIREKTEM BONDEN GLATTER METALLISCHER OBERFLÄCHENSCHICHTEN SOWIE ENTSPRECHENDES LEISTUNGSELEKTRONSICHES MODUL UND ENTSPRECHENDE LEISTUNGSELEKTRONISCHE BAUGRUPPE**

(30) Priorität: 30.03.2020 DE 102020204119
(71) Anmelder: Fraunhofer-Gesellschaft zur Förderung der angewandten Forschung e.V., 80686 München (DE)
(72) Erfinder: Yu, Zechun, 91058 Erlangen (DE); Bayer, Christoph Friedrich, 91058 Erlangen (DE); Schletz, Andreas, 91058 Erlangen (DE)
(74) Vertreter: Gagel, Roland

(57) **Zusammenfassung**

Bei einem Verfahren zur Verbindung von Komponenten bei der Herstellung leistungselektronischer Module oder Baugruppen werden zu verbindende Flächen der Komponenten (3, 4, 5, 9) mit einer metallischen Oberflächenschicht (1) bereitgestellt oder versehen, die eine für direktes Bonden ausreichend glatte Oberfläche aufweist oder geglättet wird, um eine für direktes Bonden ausreichend glatte Oberfläche zu erhalten. Die Oberflächenschichten (1) der zu verbindenden Flächen werden dann mit einem Druck von mindestens 5 MPa bei erhöhter Temperatur gegeneinander gepresst, so dass sie sich unter Bildung einer einzigen Schicht (2) miteinander verbinden. Das Verfahren ermöglicht eine einfache und schnelle Verbindung auch von größeren Kontaktflächen, die den hohen Anforderungen leistungselektronischer Module genügt. Die zu verbindenden Komponenten können wie folgt sein: ein oder mehrere Halbleiterbauelemente (4) und ein Substrat (3); zwei miteinander zu verbindende Halbleiterbauelemente (1) (z.B. zwei Dioden (4) oder zwei MOSFETs (4)); ein oder mehrere streifenförmig ausgebildete elektrische Verbindungselemente (5) und ein Halbleiterbauelement (4) und ein Substrat (3); ein Halbleiterbauelement (4) (MOSFET) und ein Kondensator (9); ein Kondensator (9) und ein Substrat (3). Beim Verbinden eines Halbleiterbauelements (4) mit einem Substrat (3) können die Oberflächenschichten (1) vor der Verbindung strukturiert oder bereits strukturiert bereitgestellt werden, so dass nach der Verbindung einzelne Schichtbereiche der gebildeten Schicht (2) durch Zwischenräume (7) elektrisch voneinander isoliert sind, und/oder können die Oberflächenschichten (1) vor der Verbindung zur Bildung von Vertiefungen strukturiert oder bereits strukturiert bereitgestellt werden, wobei vor der Verbindung ein Isolationsmaterial (6) in ein oder mehrere der Vertiefungen der Oberflächenschichten (1) eingebracht wird, das vorzugsweise bei der Herstellung der Verbindung durch die erhöhte Temperatur aufschmilzt, z.B. ein Glasmaterial. Beim Verbinden mehrerer Halbleiterbauelemente (4) mit einem Substrat (3) können die Halbleiterbauelemente (4) aus unterschiedlichen Materialien bestehen (ein ultradünnes Halbleiterbauelement (4) aus GaN und ein ultradünnes Halbleiterbauelement (4) aus SiC) oder gleich oder unterschiedlich angeordnet sein (ein erster MOSFET (4) mit der aktiven Fläche nach unten und ein zweiter MOSFET (4) mit der aktiven Fläche nach unten oder nach oben). Bei zwei auf einem Substrat (3) nebeneinander angeordneten, gleich gerichteten MOSFETs (4) kann ein weiteres Substrat (3) über die beiden MOSFETS (4) aufgebracht werden. Beim Stapeln mehrerer MOSFETs (4) werden sie versetzt zueinander gestapelt. Die zu verbindenden Flächen der Komponenten (3, 4, 5, 9) können mit einer Oberflächenschicht (1) aus Ag oder einem Ag als Hauptbestandteil enthaltenden metallischen Material als die metallische Oberflächenschicht (1) bereitgestellt oder versehen werden. Auch andere Materialien wie beispielsweise Cu, Au, Ti, Pt oder Al können für die Oberflächenschichten (1) genutzt werden.

## Beschreibung

### Technisches Anwendungsgebiet

Die Erfindung betrifft ein Verfahren zur Verbindung von Komponenten bei der Herstellung leistungselektronischer Module oder Baugruppen, die insbesondere einen oder mehrere Halbleiterbauelemente auf einem Substrat oder aufeinander aufweisen, sowie leistungselektronische Module oder Baugruppen, die unter Anwendung des Verfahrens hergestellt wurden.

Leistungselektronische Module, wie sie beispielsweise als Umrichter, Wechselrichter, Transformatoren, Schaltnetzteile oder Verstärker zum Einsatz kommen, weisen in der Regel einen Schaltungsträger aus einem bspw. keramischen Substrat auf, auf dem die für die jeweilige Anwendung erforderlichen Halbleiterbauelemente wie beispielsweise Leistungstransistoren, Dioden oder ähnlich ausgeführte Halbleiterbauelemente (bspw. Si-basierter RC-Snubber) aufgebracht und elektrisch verschaltet sind. Der Schaltungsträger kann mit seiner Rückseite auch mit einer Bodenplatte verbunden werden, die als Wärmesenke zur Kühlung des Moduls ausgebildet sein kann.

Im Allgemeinen kann auch nur eine Fügung von zwei oder mehr Halbleiterbauelementen oder eines Halbleiterbauelements mit einer oder mehreren metallischen Anschlusslaschen für die leistungselektronische Anwendung unter Verwendung des in der vorliegenden Patentanmeldung beschriebenen Verfahrens hergestellt werden.

Die einzelnen Komponenten leistungselektronischer Module, also insbesondere die Halbleiterbauelemente, das Substrat und auch elektrische Verbindungselemente, müssen bei der Herstellung des leistungselektronischen Moduls geeignet miteinander verbunden werden. An diese Verbindung werden aufgrund der hohen thermischen Belastungen beim Betrieb leistungselektronischer Module und auch der dabei auftretenden hohen Ströme und Spannungen hohe Anforderungen gestellt, wie sie in anderen Bereichen der Elektronik wie beispielsweise der Mikroelektronik oder integrierten Schaltkreise nicht auftreten. Die in der Leistungselektronik eingesetzten Verbindungstechniken sollen insbesondere zur Herstellung großflächiger Kontakte geeignet sein, bei denen die zu verbindenden Flächen Flächeninhalte von mehr als 2 mm x 2 mm aufweisen. Gleichzeitig sollten die Toleranzen bei der Verbindung bei unter 100 µm liegen. Die Verbindungen müssen auch hohe Betriebstemperaturen von >200 °C aushalten können.

### Stand der Technik

Bisher werden bei der Herstellung von leistungselektronischen Modulen die einzelnen Komponenten durch Techniken wie Löten, Sintern oder Kleben miteinander verbunden. Diese Techniken bergen jedoch bei der Verbindung von Wide-Bandgap-Bauelementen (SiC, GaN, etc.) Herausforderungen. Beim Sintern ist der Auftrag einer Sinterpaste oder eines Sinterfilms erforderlich. Beim Auftragen des Sintermaterials kann nur eine beschränkte Prozessgenauigkeit aufrechterhalten werden. Sinterschichten können zudem eine unerwünschte Porosität aufweisen. Zudem muss die Belastung durch elektrisch leitfähige Partikel mit äußerster Sorgfalt behandelt werden, da solche Verunreinigungen Folgeprozesse sowie den Betrieb und die Lebensdauer von leistungselektronischen Komponenten gefährden. Auch die Technik des Lötens ermöglicht nur eine stark beschränkte Prozessgenauigkeit und andere ähnliche Herausforderungen.

Eine weitere bekannte Technik, die bei der Herstellung leistungselektronischer Module eingesetzt wird, ist das Thermokompressionsbonden. Für diese Verbindungstechnik ist allerdings die Herstellung von Bumps und Bondpads auf den zu verbindenden Flächen notwendig. Hierbei ergeben sich Schwierigkeiten bei der genauen Ausrichtung bzw. Positionierung der Bumps zu den Bondpads.

In der US 2019/0047093 A1 wird als Alternative zu einem Lötmaterial ein Bondingmaterial in Form einer amorphen Silberschicht vorgeschlagen, die jeweils auf die zu verbindenden Flächen aufgebracht wird. Die beiden Flächen werden dann in Kontakt gebracht und durch Erhitzen miteinander verbunden. Diese Verbindung kann ohne Anwendung von Druck oder durch leichtes Anpressen mit einem Druck von ≤1 MPa erfolgen. Die Verbindung basiert auf dem Hillockwachstum in den amorphen Silberschichten. Über eine Eignung dieser Verbindungstechnik für die Leistungselektronik lässt sich dieser Druckschrift kein Hinweis entnehmen. Das Bereitstellen einer amorphen Silberschicht erfordert eine Temperaturvorbehandlung, indem zunächst eine kristalline Silberschicht mit bekannten Verfahren auf den zu verbindenden Flächen abgeschieden und diese dann an der Oberfläche durch Temperaturbehandlung in einer sauerstoffreichen Atmosphäre in eine amorphe Silberschicht umgewandelt wird.

Die Aufgabe der vorliegenden Erfindung besteht darin, ein Verfahren zur Verbindung von Komponenten bei der Herstellung leistungselektronischer Module und Baugruppen in verschiedenen Atmosphären bspw. Luft, Vakuum oder Stickstoff anzugeben, das mit einer einfachen Verfahrensführung eine zuverlässige, langlebige und präzise Verbindung auch größerer Flächen von >2 mm x 2 mm ermöglicht, die den Anforderungen der Leistungselektronik standhält.

### Darstellung der Erfindung

Die Aufgabe wird mit dem Verfahren gemäß Patentanspruch 1 gelöst. Die Patentansprüche 11 und 13 geben ein leistungselektronisches Modul bzw. eine leistungselektronische Baugruppe an, bei dem bzw. der eine oder mehrere Komponenten durch das vorgeschlagene Verfahren miteinander verbunden wurden. Vorteilhafte Ausgestaltungen des Verfahrens sowie des leistungselektronischen Moduls und der leistungselektronischen Baugruppe sind Gegenstand der abhängigen Patentansprüche oder lassen sich der nachfolgenden Beschreibung sowie den Ausführungsbeispielen entnehmen.

Mit dem vorgeschlagenen Verfahren werden Komponenten bei der Herstellung leistungselektronischer Module oder Baugruppen (z.B. Halbleiterbauelementstapel, Halbleiterbauelement mit Kontaktierung, etc.) miteinander verbunden. Die leistungselektronischen Module weisen insbesondere einen oder mehrere Halbleiterbauelemente auf einem Substrat, bspw. einem keramischen Substrat, auf. Die leistungselektronischen Baugruppen können bspw. mehrere Halbleiterbauelemente aufeinander aufweisen. Unter leistungselektronischen Modulen bzw. dem Begriff der Leistungselektronik werden dabei Systeme mit elektrischen Schaltungen verstanden, die mit Spannungen von ≥10 V und/oder Strömen von ≥10 A betrieben werden und eine entsprechend hohe Wärmebelastung aufweisen. Bei dem Verfahren werden zu verbindende Flächen der Komponenten, die häufig einen Flächeninhalt von wenigstens 2x2 mm² aufweisen, mit einer metallischen Oberflächenschicht bereitgestellt oder mit einer derartigen Oberflächenschicht versehen, die eine für direktes Bonden ausreichend glatte Oberfläche aufweist oder geglättet wird, um eine für direktes Bonden ausreichend glatte Oberfläche zu erhalten. Die Technik des direkten Bondens ist aus der Halbleiter- und Mikrosystemtechnik beispielsweise zur Verbindung von Wafern bekannt. Die Rauheit der entsprechend glatten Oberfläche liegt dabei vorzugsweise bei Ra ≤ 0,2 µm (Mittenrauwert) und/oder Rz ≤ 1 µm (gemittelte Rautiefe). Die Oberflächenschichten der zu verbindenden Flächen werden dann mit einem Druck von mindestens 5 MPa bei erhöhter Temperatur gegeneinander gepresst, so dass sie sich unter Bildung einer einzigen Schicht miteinander verbinden. Die erhöhte Temperatur liegt vorzugsweise bei ≥180 °C, hängt jedoch vom jeweils eingesetzten metallischen Material ab. Besonders vorteilhaft wird Ag oder ein Ag als Hauptbestandteil enthaltendes metallisches Material als Material der Oberflächenschicht verwendet, da sich dieses Material bei relativ niedrigen Temperaturen durch direktes Bonden miteinander verbinden lässt. Auch andere Materialien wie beispielsweise Cu, Au, Ti, Pt oder Al können für die Oberflächenschichten genutzt werden.

Das vorgeschlagene Verfahren kommt daher ohne zusätzliche Sinterpasten oder Lote aus und lässt sich sehr einfach und schnell durchführen. Es ist insbesondere für flächige Kontakte mit größeren Flächen ≥ 2x2 mm² geeignet und ermöglicht gleichzeitig sehr enge Toleranzen von < 100 µm bei der Verbindung. Die damit hergestellten Verbindungen sind auch bei Betriebstemperaturen > 200°C stabil. Mit dem Verfahren können auch ultradünne Halbleiterbauelemente (< 20 µm) miteinander, mit anderen Halbleiterbauelementen oder mit dem Substrat verbunden werden. Das Verfahren lässt sich kostengünstig durchführen und ermöglicht das Verbinden unterschiedlicher Werkstoffe wie beispielsweise Si, SiC, GaN, GaO, GaAs ,AlN oder Diamant miteinander. Mit dem Verfahren lassen sich auch unterschiedliche Halbleitermaterialien mit elektrischen Leitern, beispielsweise aus Cu oder Al, verbinden. Damit können sowohl die Halbleiterbauelemente mit dem Substrat verbunden als auch 3D-Chip-Stapel aus den unterschiedlichsten Halbleiterbauelementen, beispielsweise Dioden, Transistoren, Kondensatoren, Sensoren etc. gebildet werden.

Vorzugsweise werden bei der Herstellung der leistungselektronischen Module Substrate mit niedrigen thermischen Ausdehnungskoeffizienten wie beispielsweise Si, GaN, SiC, Al2O3, AlN oder Si3N4 eingesetzt. Diese Substrate können an der Oberfläche auch zusätzlich geglättet werden, beispielsweise mittels physikalischen und chemischen Ätzverfahren, mechanischem Polieren und Laserabtrag und einer chemisch oder physikalisch aufgebrachten Metallisierung bspw. aufgedampftes und aufgesputtertes Metall, um die Abscheidung einer möglichst glatten metallischen Oberflächenschicht zu ermöglichen.

In vorteilhaften Ausgestaltungen des Verfahrens werden ein oder mehrere der Halbleiterbauelemente über die metallischen Oberflächenschichten mit dem Substrat und/oder unter Bildung eines Bauelementestapels miteinander verbunden. Weiterhin besteht auch die Möglichkeit, für eine elektrische Kontaktierung bzw. Verbindung der Halbleiterbauelemente anstelle eines herkömmlichen Bonddrahts ein streifenförmig ausgebildetes elektrisches Verbindungselement einzusetzen, das gemäß dem vorgeschlagenen Verfahren mit dem jeweiligen Halbleiterbauelement verbunden wird. Die entsprechenden Kontaktflächen werden dabei wiederum mit der metallischen Oberflächenschicht, bspw. aus Ag, bereitgestellt oder beschichtet. Dadurch lassen sich bei der Herstellung der leistungselektronischen Module elektrische Verbindungen sehr schnell und einfach realisieren.

Die für die Verbindung eingesetzten metallischen Oberflächenschichten können vor der Verbindung auch geeignet strukturiert oder bereits strukturiert bereitgestellt werden, so dass nach der Verbindung einzelne Schichtbereiche der daraus gebildeten Schicht durch Zwischenräume elektrisch voneinander isoliert sind. Damit lassen sich geeignete elektrische Verschaltungen mit Hilfe der Verbindungsschichten realisieren.

Die Oberflächenschichten können auch zur Bildung von Vertiefungen strukturiert oder bereits strukturiert bereitgestellt und in eine oder mehrere der Vertiefungen vor der Verbindung ein Isolationsmaterial eingebracht werden. Vorzugsweise wird ein Isolationsmaterial verwendet, das bei Herstellung der Verbindung durch die erhöhte Temperatur aufschmilzt. Isolationsmaterial und Wahl der Temperatur für die Verbindung können dabei aufeinander abgestimmt werden, bspw. auch durch Wahl einer entsprechend höheren Temperatur. Mit dem Isolationsmaterial und der entsprechenden Strukturierung der Oberflächenschichten ist eine sehr feine Isolation einzelner Bereiche des leistungselektronischen Moduls möglich, also eine Isolation mit hoher Auflösung. Besonders vorteilhaft wird als Isolationsmaterial ein Glasmaterial verwendet. Es steht eine große Palette an aufschmelzenden Gläsern für Prozesstemperaturen ab 400 °C zur Verfügung. Durch Nutzung derartiger Gläser - oder auch anderer Isolationsmaterialien - verbinden sich die elektrisch isolierenden Verbindungsstellen stoffschlüssig, beispielsweise durch Verschmelzen, Versintern oder je nach Wahl des Isolationsmaterials auch durch eine chemische Reaktion.

Ein entsprechendes leistungselektronisches Modul mit einem oder mehreren Halbleiterbauelementen auf einem Substrat, insbesondere einem keramischen Substrat, zeichnet sich dadurch aus, dass eine oder mehrere der Komponenten des leistungselektronischen Moduls durch das vorgeschlagene Verfahren miteinander verbunden sind. Bei den Komponenten kann es sich um das Substrat und ein oder mehrere Halbleiterbauelemente, um aufeinander gestapelte Halbleiterbauelemente oder auch um elektrische Verbindungselemente handeln, die mit einem oder mehreren Halbleiterbauelementen und/oder dem Substrat verbunden sind.

### Kurze Beschreibung der Zeichnungen

Das vorgeschlagene Verfahren wird nachfolgend anhand von Ausführungsbeispielen in Verbindung mit den Zeichnungen nochmals näher erläutert. Hierbei zeigen:
Fig. 1 ein Beispiel für die Verbindung von zwei ultradünnen Halbleiterbauelementen mit einem Substrat gemäß dem vorgeschlagenen Verfahren;
Fig. 2 ein Beispiel für die Stapelung von zwei Halbleiterdioden gemäß dem vorgeschlagenen Verfahren;
Fig. 3 ein Beispiel für die Verbindung eines Halbleiterbauelementes mit einem Substrat unter Nutzung von zusätzlichem Isolationsmaterial gemäß dem vorgeschlagenen Verfahren;
Fig. 4 ein Beispiel für die elektrische Verbindung eines Halbleiterbauelementes über ein elektrisches Verbindungselement mit einem Kontaktpad auf dem Substrat gemäß dem vorgeschlagenen Verfahren;
Fig. 5 Beispiele für die Stapelung von MOSFETs übereinander (Teilabbildung A) und die Verbindung von MOSFETs mit einem Substrat (Teilabbildung B) gemäß dem vorgeschlagenen Verfahren;
Fig. 6 ein Beispiel für die Verbindung von MOSFETs mit zwei Substraten gemäß dem vorgeschlagenen Verfahren;
Fig. 7 Beispiele für die Stapelung von MOSFETs auf und neben einem vertikalen Si-Kondensator sowie die Verbindung mit einem Substrat gemäß dem vorgeschlagenen Verfahren;
Fig. 8 ein Beispiel für eine alternative Anordnung zur Anordnung der Figur 7;
Fig. 9 ein Beispiel für die Stapelung von MOSFETs auf einem lateralen Si-Kondensator gemäß dem vorgeschlagenen Verfahren; und
Fig. 10 ein Beispiel für eine alternative Anordnung zur Anordnung der Figur 9.

### Wege zur Ausführung der Erfindung

Bei dem vorgeschlagenen Verfahren werden zu verbindende Flächen der Komponenten eines leistungselektronischen Moduls oder einer leistungselektronischen Baugruppe mit der Technik des direkten Metall-Diffusions-Bondens verbunden. Dies ermöglicht sowohl die Verbindung von Halbleiterbauelementen des leistungselektronischen Moduls mit dem Substrat als auch eine 3D-Stapelung der Bauelemente oder Bauelementchips auf dem Substrat. Damit lassen sich innovative Schaltungskonzepte durch 3D-Power-Integration realisieren, die hervorragende Hochfrequenzeigenschaften mit einem mechanisch robusten und verlustarmen Substrat kombinieren.

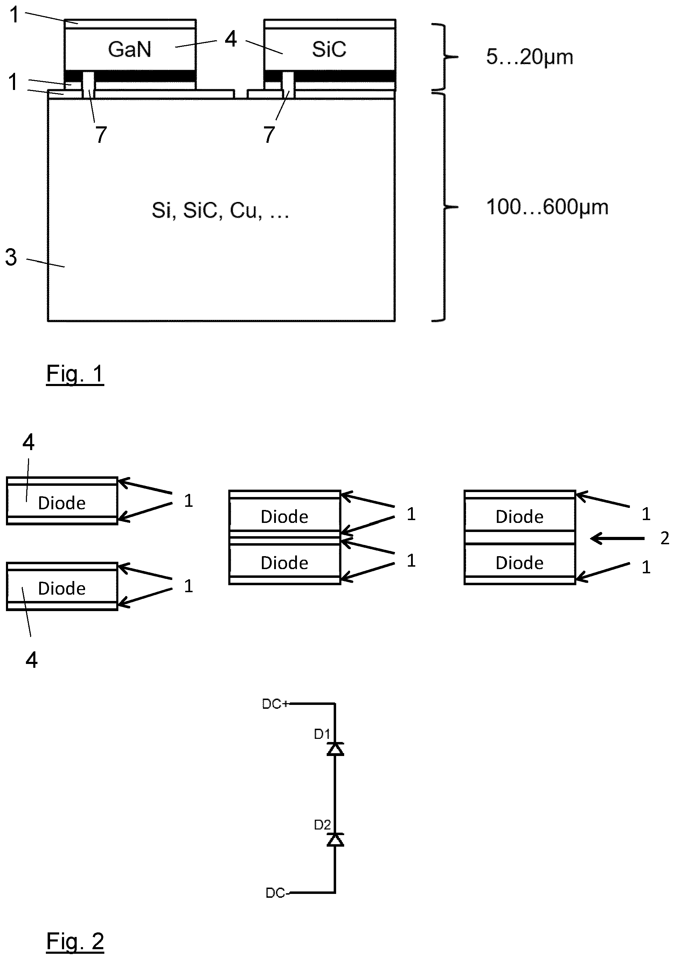

Das vorgeschlagene Verfahren ermöglicht dabei auch die Verbindung von ultrafeinen Wide-Bandgap-Bauelementen mit einer Dicke von < 20 µm mit dem Substrat oder auch miteinander oder mit anderen Halbleiterbauelementen. Dies ist in Figur 1 schematisch dargestellt, bei der zwei derartige ultradünne Halbleiterbauelemente 4, im vorliegenden Fall aus GaN und SiC, mit dem Substrat 3 des leistungselektronischen Moduls, beispielsweise aus Si, SiC, Cu oder einem anderen geeigneten Material, verbunden werden. Hierzu wird auf die Oberfläche des Substrats 3 eine metallische Oberflächenschicht, im vorliegenden und den nachfolgenden Beispielen eine kristalline Ag-Schicht 1, aufgebracht und für die spätere Funktion einer elektrischen Verschaltung bzw. elektrischer Verbindungen strukturiert. In gleicher Weise wird an der Unterseite der Halbleiterbauelemente 4 ebenfalls eine derartige Ag-Schicht 1 aufgebracht. Diese Oberflächenschichten werden miteinander in Kontakt gebracht und die jeweiligen Bauelemente 4 mit entsprechend hohem Druck, in den vorliegenden Beispielen im Bereich von > 10 bis 35 MPa, und bei erhöhter Temperatur, im Falle von Ag-Schichten vorzugsweise im Bereich zwischen 240°C und 280°C, für bspw. etwa 1 bis 15 Minuten gegen das Substrat 3 gepresst. Dadurch verbinden sich die aneinander liegenden Ag-Schichten 1 zu einer einzigen Verbindungsschicht (in Figur 1 nicht erkennbar). Durch die Strukturierung der Ag-Schichten 1 wurde in diesem Fall ein isolierender Zwischenraum 7 bei der Verbindung gebildet, der einzelne Bereiche der gebildeten Verbindungsschicht voneinander isoliert. Im Beispiel der Figur 1 ist eine entsprechende Ag-Schicht 1 auch auf der Oberseite der Bauelemente 4 aufgebracht, die entweder eine Kontaktierung dieser Bauelemente bei der weiteren Prozessierung oder auch eine Stapelung weiterer Halbleiterbauelemente ermöglicht.

Figur 2 zeigt ein Beispiel für eine Stapelung zweier Dioden als Halbleiterbauelemente 4, um eine im unteren Teil der Figur dargestellte Reihenschaltung der Dioden zu erreichen. Die beiden Dioden tragen in diesem Beispiel wiederum beidseitig eine Ag-Schicht 1 als metallische Oberflächenschicht, werden anschließend übereinander gelegt und durch Anwendung von Druck bei erhöhter Temperatur durch direktes Bonden miteinander verbunden. Die beiden aufeinander liegenden Ag-Schichten 1 bilden bei dieser Verbindung eine einzelne Ag-Schicht als Verbindungsschicht 2, wie dies im rechten Teil der Figur angedeutet ist. Eine derartige Stapelung zweier Halbleiterbauelemente 4 bei leistungselektronischen Modulen kann selbstverständlich auch mit anderen Halbleiterbauelementen wie Transistoren oder Kondensatoren und auch mit mehr als zwei Halbleiterbauelementen 4 erfolgen. Die Kontaktflächen derartiger Halbleiterbauelemente weisen bei leistungselektronischen Modulen in der Regel einen Flächeninhalt von mindestens 2x2 mm² auf.

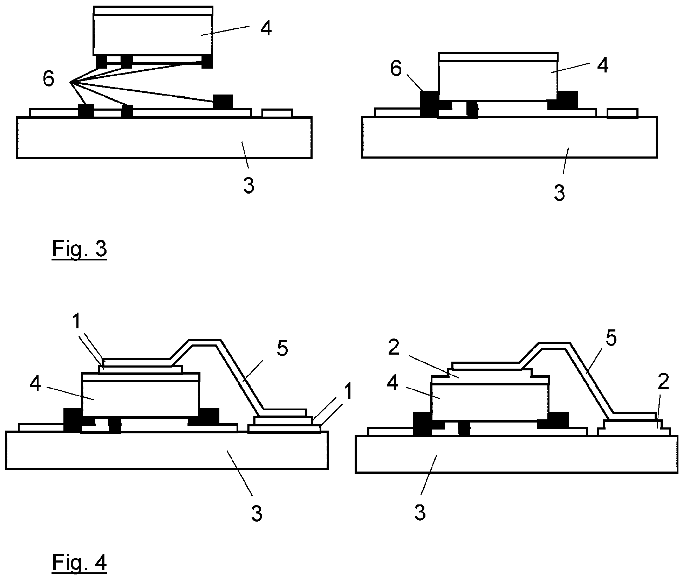

Um einzelne Schichtbereiche der durch die Verbindung erhaltenen einzelnen Verbindungsschicht 2 voneinander zu isolieren, können neben einer reinen Strukturierung wie bei Figur 1 auch zusätzliche Isolatoren eingesetzt werden, wie dies in Verbindung mit Figur 3 beispielhaft dargestellt ist. In diesem Beispiel werden die Ag-Schichten 1 wiederum zunächst strukturiert. Anschließend wird in entsprechende Vertiefungen oder auch lokal auf die Oberfläche dieser Schichten 1 ein Isolationsmaterial 6 eingefüllt bzw. aufgebracht, wie dies im linken Teil der Figur 3 schematisch angedeutet ist. In diesem Beispiel wird ein Glasmaterial als Isolationsmaterial 6 eingesetzt. Während die beiden Ag-Schichten 1 dann unter Anwendung von Druck bei erhöhter Temperatur miteinander verbunden werden, verbinden sich auch die elektrisch isolierenden Verbindungsstellen stoffschlüssig und bilden dadurch eine entsprechende Isolation in dem erhaltenen Verbund, wie im rechten Teil der Figur 3 zu erkennen. Die stoffschlüssige Verbindung erfolgt dabei aufgrund der erhöhten Temperatur, beispielsweise durch Versintern, durch chemische Reaktion oder insbesondere - wie im vorliegenden Beispiel - durch Verschmelzen. Bei Nutzung eines Glasmaterials als isolierendem Material 6 werden das Glasmaterial und die bei dem Verbinden eingesetzten Temperaturen so aufeinander abgestimmt, dass das Glasmaterial aufschmilzt und sich entsprechend stoffschlüssig verbindet.

Das vorgeschlagene Verfahren ermöglicht auch die elektrische Verbindung einzelner Bereiche des leistungselektronischen Moduls über entsprechende elektrische Verbindungselemente 5, die in diesem Fall streifenförmig ausgebildet sind. Auf die jeweiligen Kontaktflächen wird hier wiederum eine Ag-Schicht 1 aufgebracht, wie dies im linken Teil der Figur 4 erkennbar ist. Durch Anwendung von Druck bei erhöhter Temperatur verbinden sich dann die entsprechenden Kontaktflächen unter Bildung einer einzigen zusammenhängenden Ag- bzw. Verbindungsschicht 2 (vgl. rechter Teil der Figur 4).

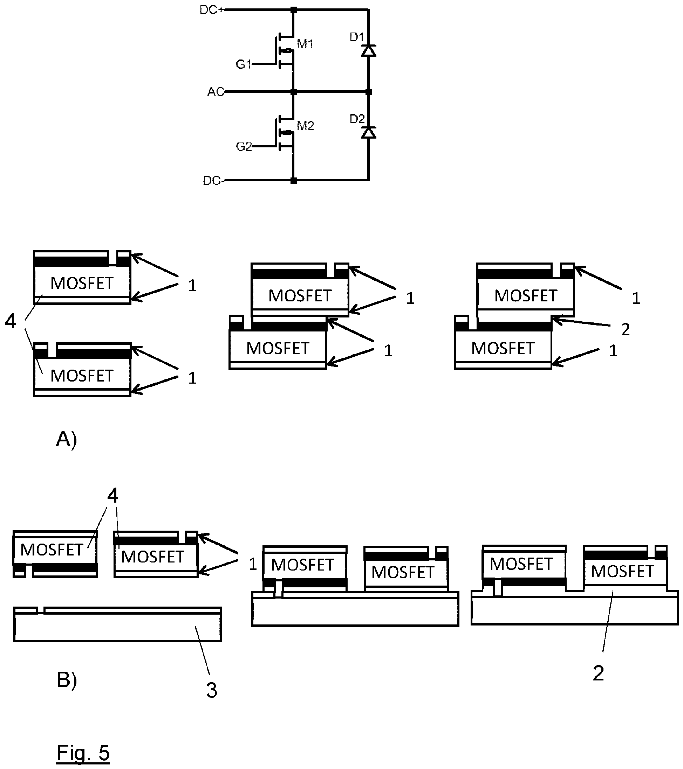

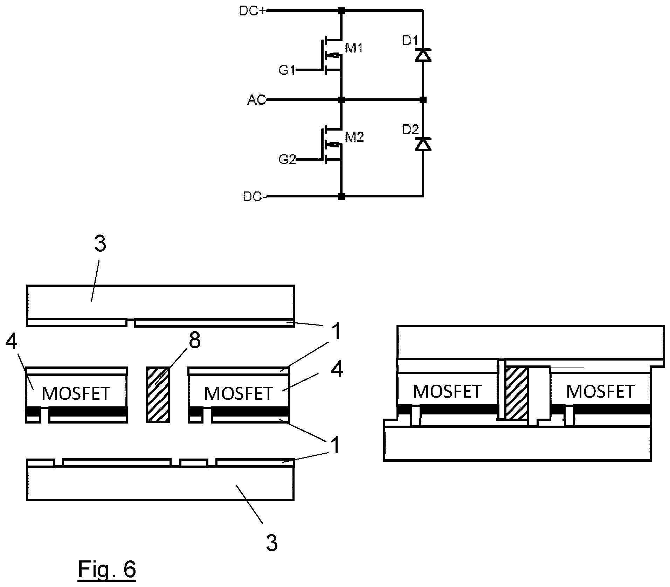

Die Figuren 5 und 6 zeigen Beispiele für die Realisierung einer im oberen Teil der Figur 5A dargestellten Schaltung auf unterschiedliche Weise. So werden im Beispiel der Figur 5A die beiden MOSFETs als Halbleiterbauelemente 4 geeignet übereinander gestapelt, um die im oberen Teil der Figur dargestellte Verschaltung dieser Transistoren zu erreichen. Die Verbindung erfolgt hierbei wiederum über direktes Bonden mittels geeigneter metallischer Oberflächenschichten, im vorliegenden Beispiel Ag-Schichten 1, die vorab geeignet strukturiert werden.

Fig. 5B zeigt eine alternative Möglichkeit, bei der die beiden MOSFETs nebeneinander auf dem Substrat 3 angeordnet und mit dem Substrat 3 verbunden werden. Figur 6 zeigt wiederum ein Beispiel einer Verbindung, bei dem über die beiden nebeneinander auf dem Substrat 3 angeordneten MOSFETs ein weiteres Substrat 3 aufgebracht wird, um über die für die Verbindung erforderlichen Ag-Schichten 1 und ein zusätzliches elektrisches Verbindungselement 8 die entsprechende Verschaltung zu realisieren. Die Verbindung der einzelnen Komponenten erfolgt hierbei wiederum durch direktes Metallbonden gemäß dem vorgeschlagenen Verfahren.

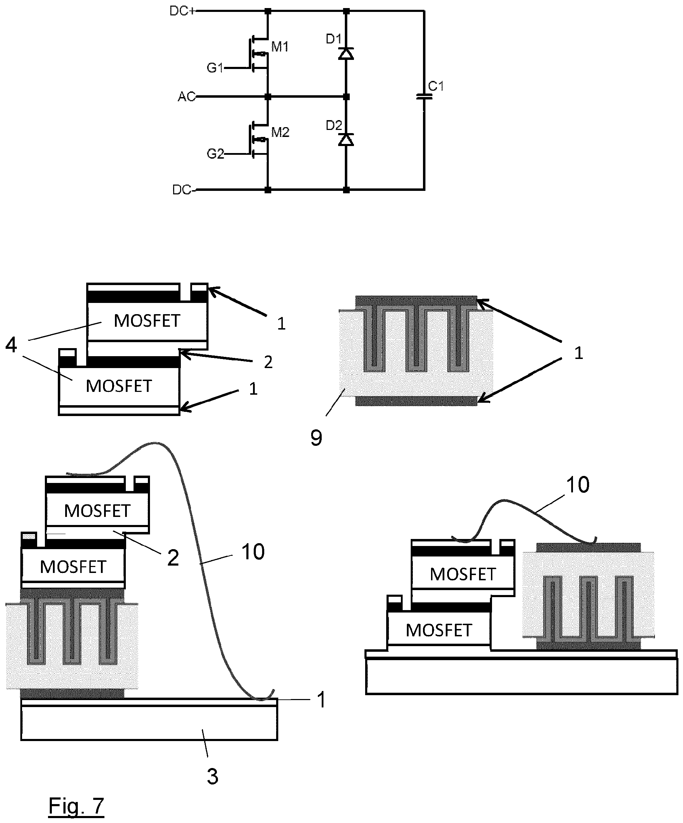

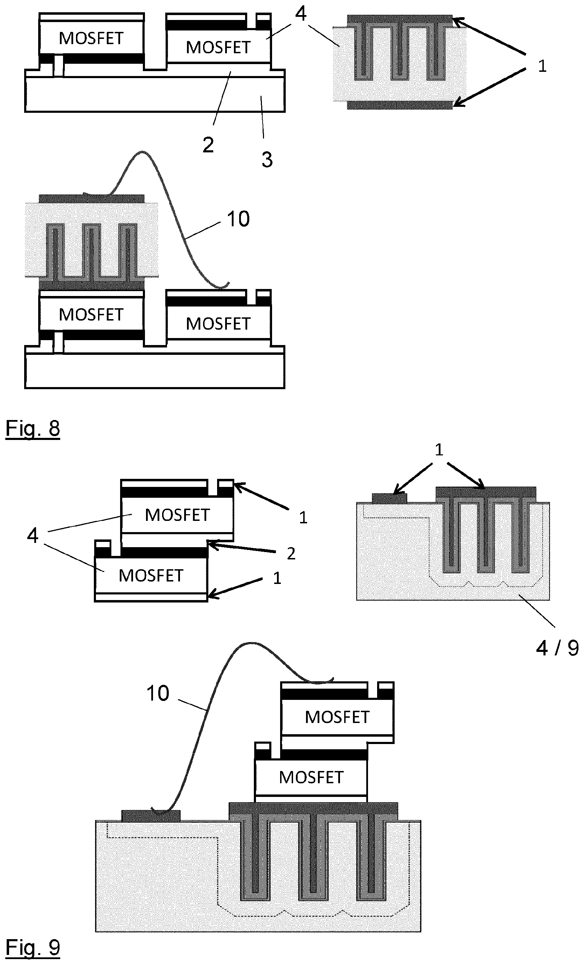

Die Figuren 7 bis 10 zeigen schließlich ein weiteres Beispiel bei dem eine Schaltung wie im oberen Teil der Figur 7 mit einem zusätzlichen Kondensator realisiert wird. Im Beispiel der Figur 7 werden hierbei der vertikale Kondensator 9 und die beiden MOSFETs auf dem Substrat übereinander gestapelt. Die elektrische Verbindung des oberen MOSFETs mit der Metallisierung auf dem Substrat 3 kann entweder über einen Bonddraht 10 oder auch in gleicher Weise wie bei Figur 4 erfolgen. Das Gleiche gilt für die zweite in Figur 7 dargestellte Alternative, bei der der vertikale Kondensator 9 neben dem Stapel aus den beiden MOSFETs auf dem Substrat 3 angeordnet wird. Figur 8 zeigt eine weitere Alternative, bei der die beiden MOSFETs nebeneinander auf dem Substrat 3 und der vertikale Kondensator 9 über einem der beiden MOSFETs gestapelt wird.

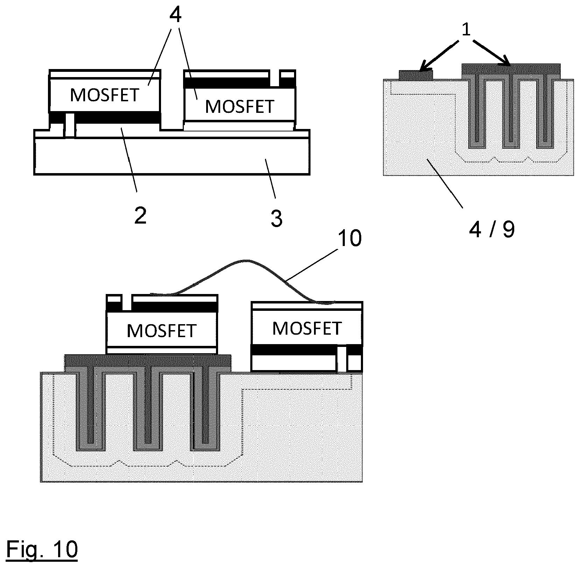

Während bei den Figuren 7 und 8 ein vertikaler Si-Kondensator eingesetzt wurde, zeigen die Figuren 9 und 10 eine Ausgestaltung mit einem lateralen Si-Kondensator 9, über dem die beiden MOSFETs in Figur 9 gestapelt werden. Figur 10 zeigt demgegenüber eine Anordnung der beiden MOSFETs nebeneinander auf dem Kondensator.

### Bezugszeichenliste

- 1: Ag-Schicht
- 2: Verbindungsschicht
- 3: Substrat
- 4: Halbleiterbauelement
- 5: elektrisches Verbindungselement
- 6: Isolationsmaterial
- 7: isolierender Zwischenraum
- 8: elektrisches Verbindungselement
- 9: Kondensator
- 10: Bonddraht

## Patentansprüche

1. Verfahren zur Verbindung von Komponenten bei der Herstellung leistungselektronischer Module oder Baugruppen, die insbesondere einen oder mehrere Halbleiterbauelemente (4) auf einem Substrat (3) oder aufeinander aufweisen,
bei dem zu verbindende Flächen der Komponenten mit einer metallischen Oberflächenschicht (1) bereitgestellt oder versehen werden, die eine für direktes Bonden ausreichend glatte Oberfläche aufweist oder geglättet wird, um eine für direktes Bonden ausreichend glatte Oberfläche zu erhalten, und die Oberflächenschichten (1) der zu verbindenden Flächen mit einem Druck von mindestens 5 MPa bei erhöhter Temperatur gegeneinander gepresst werden, so dass sie sich unter Bildung einer einzigen Schicht (2) miteinander verbinden.

2. Verfahren nach Anspruch 1,
**dadurch gekennzeichnet,**
**dass** die Oberflächenschichten (1) der zu verbindenden Flächen mit einem Druck von > 10 MPa gegeneinander gepresst werden.

3. Verfahren nach Anspruch 1 oder 2,
**dadurch gekennzeichnet,**
**dass** die zu verbindenden Flächen der Komponenten mit einer Oberflächenschicht (1) aus Ag oder einem Ag als Hauptbestandteil enthaltenden metallischen Material als die metallische Oberflächenschicht (1) bereitgestellt oder versehen werden.

4. Verfahren nach einem der Ansprüche 1 bis 3,
**dadurch gekennzeichnet,**
**dass** als Komponenten ein oder mehrere der Halbleiterbauelemente (4) mit dem Substrat (3) verbunden werden.

5. Verfahren nach einem der Ansprüche 1 bis 4,
**dadurch gekennzeichnet,**
**dass** als Komponenten mehrere der Halbleiterbauelemente (4) unter Bildung eines Bauelementstapels miteinander verbunden werden.

6. Verfahren nach einem der Ansprüche 1 bis 4,
**dadurch gekennzeichnet,**
**dass** als Komponenten ein oder mehrere der Halbleiterbauelemente (4) mit einem oder mehreren streifenförmig ausgebildeten elektrischen Verbindungselementen (5) verbunden werden.

7. Verfahren nach einem der Ansprüche 1 bis 6,
**dadurch gekennzeichnet,**
**dass** die Oberflächenschichten (1) vor der Verbindung strukturiert oder bereits strukturiert bereitgestellt werden, so dass nach der Verbindung einzelne Schichtbereiche der gebildeten Schicht (2) durch Zwischenräume (7) elektrisch voneinander isoliert sind.

8. Verfahren nach einem der Ansprüche 1 bis 7,
**dadurch gekennzeichnet,**
**dass** die Oberflächenschichten (1) vor der Verbindung zur Bildung von Vertiefungen strukturiert oder bereits strukturiert bereitgestellt werden, wobei vor der Verbindung ein Isolationsmaterial (6) in ein oder mehrere der Vertiefungen der Oberflächenschichten (1) eingebracht wird.

9. Verfahren nach Anspruch 8,
**dadurch gekennzeichnet,**
**dass** das Isolationsmaterial (6) und die erhöhte Temperatur so gewählt werden, dass das Isolationsmaterial (6) bei der Verbindung der Oberflächenschichten (1) durch die erhöhte Temperatur aufschmilzt.

10. Verfahren nach Anspruch 8 oder 9,
**dadurch gekennzeichnet,**
**dass** als Isolationsmaterial (6) ein Glasmaterial eingesetzt wird.

11. Leistungselektronisches Modul, das einen oder mehrere Halbleiterbauelemente (4) auf einem Substrat (3) aufweist, wobei eine oder mehrere Komponenten des leistungselektronischen Moduls durch das Verfahren gemäß einem oder mehreren der vorangehenden Patentansprüche miteinander verbunden sind.

12. Leistungselektronisches Modul nach Anspruch 11,
**dadurch gekennzeichnet,**
**dass** als Komponenten ein oder mehrere der Halbleiterbauelemente (4) durch das Verfahren mit dem Substrat (3) verbunden sind.

13. Leistungselektronische Baugruppe, die eines oder mehrere Halbleiterbauelemente (4) aufweist, wobei eine oder mehrere Komponenten der leistungselektronischen Baugruppe durch das Verfahren gemäß einem oder mehreren der Patentansprüche 1 bis 10 miteinander verbunden sind.

14. Leistungselektronisches Modul oder leistungselektronische Baugruppe nach einem der Ansprüche 11 bis 13,
**dadurch gekennzeichnet,**
**dass** als Komponenten mehrere der Halbleiterbauelemente (4) unter Bildung eines Bauelementstapels durch das Verfahren miteinander verbunden sind.

15. Leistungselektronisches Modul oder leistungselektronische Baugruppe nach einem der Ansprüche 11 bis 14,
**dadurch gekennzeichnet,**
**dass** als Komponenten ein oder mehrere der Halbleiterbauelemente (4) durch das Verfahren mit einem oder mehreren streifenförmig ausgebildeten elektrischen Verbindungselementen (5) verbunden sind.
